# EUROPÄISCHE PATENTANMELDUNG

(11) **EP 2 139 103 A2**
(43) Veröffentlichungstag der Anmeldung: **30.12.2009**
(21) Anmeldenummer: 09163455.0
(22) Anmeldetag: 23.06.2009
(51) Int. Cl.: H02M 1/12

(54) **Schwingungsfilter**

(30) Priorität: 27.06.2008 DE 102008030986
(71) Anmelder: SIEMENS AKTIENGESELLSCHAFT, 80333 München (DE)
(72) Erfinder: Kramer, Hagen, 91056, Erlangen (DE); Strobl, Bernhard, 91080, Uttenreuth (DE)

(57) **Zusammenfassung**

Die Erfindung bezieht sich auf ein Schwingungsfilter (16, 18) mit
- einem Netzanschluss (2) zum Verbinden mit einem elektrischen Versorgungsnetz und
- einem Geräteanschluss (4) zum Verbindung mit einer Oberschwingungsströme erzeugenden Geräte-Einheit (5, 9, 12, 19),
- mindestens einer Induktivität (L6, L₁₀), und
- mindestens einem parallel zu den Anschlüssen (2, 4) verlaufenden Querzweig,
- wobei einer der Querzweige einen Kondensator (C13) und in Reihe hierzu in einem Querzweigabschnitt mindestens ein weiteres elektrisches Bauteil (R15) umfasst, wobei dem Querzweig eine Filter-Frequenz zugeordnet ist.

Das erfindungsgemäße Schwingungsfilter (16, 18) weist eine besonders gute Filterwirkung auf und seine Bauteile (C13, R15, L₁₀) sind einerseits gering dimensioniert und während des Filterbetriebs wenig belastet.

Hierzu ist das Schwingungsfilter (16, 18) durch einen Überbrückungszweig gekennzeichnet, der den Querzweigabschnitt überbrückt, wobei der Überbrückungszweig bei mindestens einer zweiten Frequenz oberhalb der Filter-Frequenz niederimpedanter ist als der Querzweigabschnitt.

## Beschreibung

Die Erfindung bezieht sich auf ein Schwingungsfilter mit einem Netzanschluss zum Verbinden mit einem elektrischen Versorgungsnetz und einem Geräteanschluss zum Verbinden mit einer Oberschwingungsströme erzeugenden Geräte-Einheit, mindestens einer Induktivität und mindestens einem parallel zu den Anschlüssen verlaufenden Querzweig, wobei einer der Querzweige einen Kondensator und in Reihe hierzu in einem Querzweigabschnitt mindestens ein weiteres elektrisches Bauteil umfasst, wobei dem Querzweig eine Filter-Frequenz zugeordnet ist.

Ein solches Schwingungsfilter ist in der DE 195 09 329 C1 bereits offenbart. So ist dort ein Schwingungsfilter mit einem Netzanschluss zum Verbinden mit einem Gleichspannungsnetz und einem Geräteanschluss zum Verbinden mit einem Oberschwingungsströme erzeugenden Stromrichter beschrieben, welches zum Unterdrücken der besagten Oberschwingungsströme zwei parallel zum Stromrichter verlaufende Querzweige aufweist. Einer der Querzweige umfasst einen Kondensator und einen Dämpfungswiderstand, wobei das eine Ende des Querzweiges an einem Anzapfpunkt einer Netzdrossel angeordnet ist, so dass ein gedämpfter Tiefpass zweiter Ordnung gebildet ist, welcher Oberschwingungen oberhalb einer Grenzfrequenz um mehr als 3 dB dämpft. Nachteilig bei diesem Schwingungsfilter ist die für hohe Oberschwingungsströme im Dämpfungswiderstand entstehende Verlustleistung.

Schwingungsfilter gemäß dem Stand der Technik werden beispielsweise in Schienenfahrzeugen als Teil der Einspeisevorrichtung eingesetzt, welche der Einspeisung elektrischer Energie in das Schienenfahrzeug dient. Hierbei wird Energie eines mit Gleichspannung oder Wechselspannung beaufschlagten Fahrleitungsdrahts in das Schienenfahrzeug geleitet und über die Einspeisevorrichtung dem Antrieb und den Bordnetzen des Schienenfahrzeugs zur Verfügung gestellt. Wird das Schienenfahrzeug mit Wechselspannung versorgt, besteht die Einspeisevorrichtung beispielsweise aus einem Transformator, der die Fahrleitungsspannung auf einen gewünschten Wert transformiert und einem Umrichter oder Vierquadrantensteller zur Verfügung stellt. Der Umrichter ist über einen Gleichspannungszwischenkreis mit einem Wechselrichter verbunden, dem ein Antriebsmotor nachgeschaltet ist. Die Frequenz der vom Wechselrichter erzeugten Spannung bestimmt die Geschwindigkeit des Schienenfahrzeugs. Bei einer Versorgung des Schienenfahrzeugs mit Gleichspannung kann die Einspeisevorrichtung einen Hochsetz- und/oder Tiefsetzsteller aufweisen, welcher die Fahrleitungsspannung auf einen geeigneten Spannungswert setzt und dem Gleichspannungszwischenkreis zur Verfügung stellt. Derartige Einspeisevorrichtungen sind zudem in kombinierter Form für Mehrsystembetrieb geeignet. Da die Umrichter und Steller Schaltelemente aufweisen, welche in bestimmten Takten angesteuert werden und hierbei störende Oberschwingungsströme erzeugen, welche nicht in das Versorgungsnetz eingespeist werden dürfen und umgekehrt die Versorgungsspannung störende Oberschwingungsspannungen aufweisen, welche Oberschwingungsströme hervorrufen, die nicht in die elektrischen Geräte-Einheiten eingespeist werden sollen, sind Schwingungsfilter in den Einspeisevorrichtungen vorgesehen. Bei einem Gleichspannungsbetrieb kann ein derartiges Schwingungsfilter beispielsweise vor dem Hochsetz- und/oder Tiefsetzsteller oder bei Direkteinspeisung der Versorgungsspannung in den Gleichspannungszwischenkreis vor dem Stromrichter angeordnet sein. Bei einem Wechselspannungsbetrieb ist ein derartiges Schwingungsfilter beispielsweise zwischen dem Transformator und dem Vierquadrantensteller angeordnet.

Aufgabe der vorliegenden Erfindung ist es, ein Schwingungsfilter der eingangs genannten Art anzugeben, welches eine gute Filterwirkung aufweist und dessen Bauteile einerseits gering dimensioniert sind und zusätzlich während des Filterbetriebs wenig belastet werden.

Die Aufgabe wird durch einen Überbrückungszweig gelöst, der den Querzweigabschnitt überbrückt, wobei der Überbrückungszweig bei mindestens einer zweiten Frequenz oberhalb der Filter-Frequenz niederimpedanter ist als der Querzweigabschnitt.

Der Überbrückungszweig ist erfindungsgemäß so gewählt, dass er mindestens für eine Frequenz oberhalb der Filter-Frequenz niederimpedanter ist als der Querzweigabschnitt. Beispielsweise könnte der Überbrückungszweig einen Saugkreis mit einer Resonanzfrequenz oder einen Tiefpass mit einer Grenzfrequenz oberhalb der Filter-Frequenz des Querzweiges aufweisen. Dadurch werden zu dämpfende Oberschwingungsströme mit einer Frequenz, bei welcher der Querzweig alleine Nachteile im Filterverhalten oder bei der Belastung von Bauteilen aufweist, über den für diesen Frequenzbereich niederimpedanten Überbrückungszweig geleitet. Der mit niederimpedanter bezeichnete Überbrückungszweig weist mit anderen Worten in diesem Frequenzbereich eine geringere Impedanz auf als der Querzweigabschnitt. Vorteilhafter Weise hat der Überbrückungszweig in einem Frequenzbereich, in welchem der Querzweig eine optimale Filterwirkung aufweist und die Bauteile nicht belastet werden, keinen wesentlichen Einfluss auf den Stromverlauf im Querzweig. Es sei aber erfindungsgemäß auch nicht ausgeschlossen, dass sich Querzweig und Überbrückungszweig in diesem Frequenzbereich sinnvoll ergänzen. Erfindungswesentlich ist vielmehr, dass hohe Oberschwingungsströme über den Überbrückungszweig geleitet werden, indem der Überbrückungszweig bei mindestens einer Frequenz oberhalb der Filter-Frequenz niederimpedanter ist als der Querzweigabschnitt. Die dem Querzweig zugeordente Filter-Frequenz sei bei einem als Tiefpass wirkenden Querzweig die Grenzfrequenz, ab der der Tiefpass ein Eingangssignal um mehr als 3 dB dämpft. Die Filter-Frequenz eines als Reihenschwingkreis wirkenden Querzweiges sei die Resonanzfrequenz, bei der der Schwingkreis seine minimale Impedanz aufweist.

Gemäß einem vorteilhaften Ausführungsbeispiel umfasst der Querzweig einen Kondensator und einen Dämpfungswiderstand.

Es kann auch als vorteilhaft angesehen werden, dass mindestens eine Induktivität in Reihe zum Geräteanschluss und vom Geräteanschluss aus vor dem Querzweig angeordnet ist.

Die Induktivität bildet zusammen mit dem Kondensator im Querzweig einen Tiefpass zweiter Ordnung. Ist als weiteres elektrisches Bauteil im Querzweigabschnitt ein Dämpfungswiderstand angeordnet, ist die Filterwirkung des Tiefpasses im Bereich der Grenzfrequenz verbessert. Im Gegenzug weist der Querzweig für hohe Frequenzen eine Belastung des Dämpfungswiderstandes auf, welche aber durch den Überbrückungszweig vermieden ist.

Vorteilhafter Weise kann vorgesehen sein, dass der Netzanschluss zum Verbinden mit einem Gleichspannungsnetz vorgesehen ist.

Ein derartiges Schwingungsfilter kann Teil der Einspeisevorrichtung eines mit Gleichspannung betriebenen Ein- oder Mehrsystemschienenfahrzeugs sein.

Es kann auch als vorteilhaft angesehen werden, dass der Geräteanschluss zum Verbinden mit einem steuerbare Leistungshalbleiter aufweisenden Bauteil vorgesehen ist.

Gemäß einem vorteilhaften Ausführungsbeispiel ist das steuerbare Leistungshalbleiter aufweisende Bauteil ein Umrichter, Stromrichter, Hochsetzsteller und/oder Tiefsetzsteller.

Ein derartiges Schwingungsfilter kann Teil der Einspeisevorrichtung eines mit Gleichspannung betriebenen Ein- oder Mehrsystemschienenfahrzeugs sein.

Es kann auch als vorteilhaft angesehen werden, dass eine Induktivität durch eine Hochsetzstellerdrossel realisiert ist.

Die Hochsetzstellerdrossel kann somit zur Filterwirkung des Schwingungsfilters beitragen, indem sie vom Hochsetzsteller aus vor dem Querzweig angeordnet ist und mit dem im Querzweig angeordneten Kondensator einen Tiefpass zweiter Ordnung darstellt. Dies reduziert die Anschaffungskosten des Schwingungsfilters.

Gemäß einem weiteren vorteilhaften Ausführungsbeispiel weist das erfindungsgemäße Schwingungsfilter eine in Reihe zum Netzanschluss angeordnete Netzdrossel auf.

Die Netzdrossel bewirkt aufgrund ihrer frequenzabhängigen Impedanz eine Glättung von störenden Schwingungen.

Es kann auch als vorteilhaft angesehen werden, dass der Querzweig an seinem einen Ende mit einem Anzapfpunkt der Netzdrossel verbunden ist.

Die Netzdrossel wird somit zusätzlich zusammen mit dem Querzweig als Teil eines Tiefpasses verwendet. Dies reduziert die Anzahl der Bauteile des Schwingungsfilters und somit dessen Anschaffungskosten.

Es kann weiter vorteilhaft vorgesehen sein, dass der Überbrückungszweig einen Kondensator aufweist.

Weist der Überbrückungszweig ausschließlich den Kondensator auf, kann dieser als Tiefpass wirken. Hierbei ist die Kapazität des Kondensators derart zu wählen, dass die Grenzfrequenz des Tiefpasses oberhalb der Filter-Frequenz des Querzweiges liegt, oder mit anderen Worten, der Kondensator im Bereich der Filter-Frequenz des Querzweiges höherimpedant ist als der Querzweigabschnitt.

Es kann auch als vorteilhaft angesehen werden, dass der Überbrückungszweig einen Kondensator und in Reihe hierzu eine Spule aufweist.

Der Überbrückungszweig wirkt als Saugkreis. Hierbei ist die Kapazität des Kondensators und die Induktivität der Spule so zu wählen, dass die Resonanzfrequenz des Saugkreises im Bereich zu filternder Oberschwingungsströme liegt, welche von dem Querzweig allein nicht optimal gefiltert werden können, sei es weil dessen Filterwirkung in diesem Frequenzbereich zu schlecht ist oder weil zu große Verlustleistungen in Bauteilen des Querzweiges auftreten. Weist der Überbrückungszweig zusätzlich zum Saugkreis einen parallel zu diesem angeordneten Kondensator auf, kann die Resonanzfrequenz des Saugkreises auch durchaus kleiner gewählt sein als die Filter-Frequenz des Querzweiges.

Es kann auch als vorteilhaft angesehen werden, dass der Überbrückungszweig eine Parallelschaltung aus einem Kondensator und einem Saugkreis aufweist.

Weitere zweckmäßige Ausgestaltungen und Vorteile der Erfindung sind Gegenstand der Beschreibung von Ausführungsbeispielen der Erfindung unter Bezug auf die Figur der Zeichnung, wobei gleiche Bezugszeichen auf gleich wirkende Bauteile verweisen.

Dabei zeigt die
- Fig.1: ein Schaltbild eines ersten Schwingungsfilter" gemäß dem Stand der Technik,
- Fig.2: ein Schaltbild eines zweiten Schwingungsfilters gemäß dem Stand der Technik,
- Fig.3: ein Schaltbild eines dritten Schwingungsfilters gemäß dem Stand der Technik,
- Fig.4: ein Schaltbild eines ersten Ausführungsbeispiels des erfindungsgemäßen Schwingungsfilters, und
- Fig.5: ein Schaltbild eines zweiten Ausführungsbeispiels des erfindungsgemäßen Schwingungsfilters.

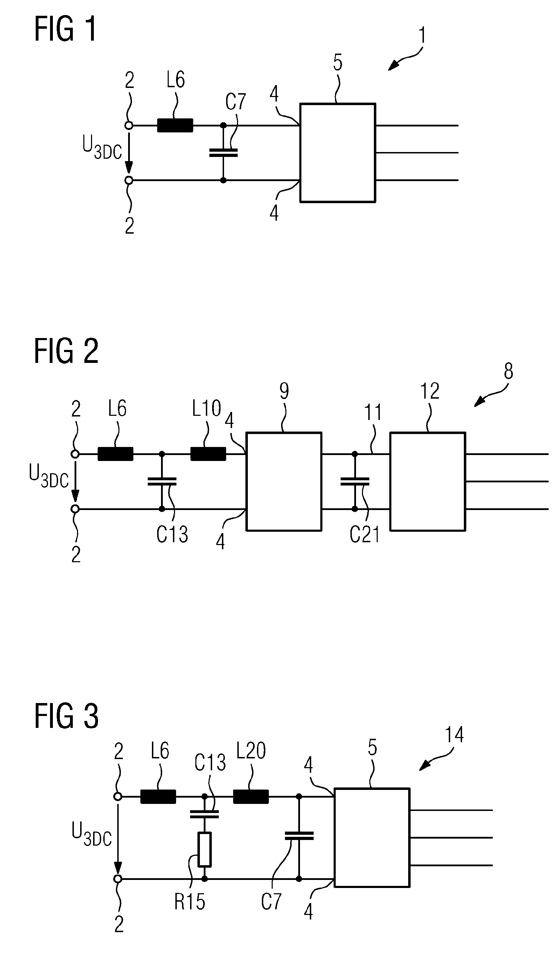

Die Figur 1 zeigt ein erstes Schwingungsfilter 1 gemäß dem Stand der Technik. Das Schwingungsfilter 1 ist mit einem Netzanschluss 2 an eine Gleichspannung U_{3DC} und mit einem Geräteanschluss 4 an einen Stromrichter 5 angeschlossen. Das Schwingungsfilter 1 umfasst eine in Reihe zum Stromrichter 5 angeordnete Netzdrossel L6 und einen parallel zum Stromrichter 5 angeordneten Glättungs-Kondensator C7. Derartige Schwingungsfilter 1 haben in Schienenfahrzeugen eine weite Verbreitung gefunden. Dabei werden die vom Stromrichter 5 hervorgerufenen Oberschwingungsströme vom Schwingungsfilter 1 gedämpft, indem der Glättungs-Kondensator C7 als Tiefpass wirkt und zusätzlich die Netzdrossel L6 die Oberschwingungsströme glättet. Um von dem Stromrichter 5 hervorgerufene Schwingungen soweit zu dämpfen, dass dies mit aktuellen Richtlinien zum Einspeisen von Störströmen in das Versorgungsnetz vereinbar ist, müssten die Netzdrossel L6 und der Glättungs-Kondensator C7 sehr groß dimensioniert werden. Dies erhöht das Gewicht und den Platzbedarf der Bauteile und ist somit unwirtschalftlich.

Die Figur 2 zeigt ein zweites Schwingungsfilter 8 gemäß dem Stand der Technik, welches gegenüber dem ersten Schwingungsfilter 1 ohne eine größere Dimensionierung von Bauteilen eine verbesserte Filterwirkung aufweist. Das Schwingungsfilter 8 umfasst einen Netzanschluss 2 und einen Geräteanschluss 4 sowie ein parallel zu den Anschlüssen 2, 4 angeordneten Querzweig mit einem Kondensator C13 und eine in Reihe zu den Anschlüssen 2, 4 angeordnete Netzdrossel L6 und Hochsetzstellerdrossel L₁₀, wobei der Querzweig zwischen diesen beiden abzweigt. Am Netzanschluss 2 des Schwingungsfilters 8 liegt eine Gleichspannung U_{3DC} an. Der Geräteanschluss 4 ist mit einem Hochsetzsteller 9 verbunden, wobei die Hochsetzstellerdrossel L₁₀ ein Teil des Hochsetzstellers 9 und des Schwingungsfilters 8 ist. Der Hochsetzsteller 9 grenzt ausgangsseitig an einen Gleichspannungskreis 11 an, welcher wiederum mit dem Eingang eines Pulswechselrichters 12 verbunden ist. Indem der Hochsetzsteller 9 die Gleichspannung U_{3DC} auf einen zur Versorgung des Pulswechselrichters 12 geeigneten Wert setzt, entstehen durch Schaltvorgänge mit einer Schaltfrequenz im Hochsetzsteller 9 störende Oberschwingungsströme, welche einerseits durch die Hochsetzstellerdrossel L₁₀ in Verbindung mit dem Kondensator C13, welche zusammen einen Tiefpass zweiter Ordnung bilden, gedämpft und andererseits durch die dem Tiefpass nachgeschaltete Netzdrossel L6 zusätzlich geglättet werden. Der Tiefpass zweiter Ordnung weist gegenüber dem in Figur 1 dargestellten Schwingungsfilter 1 eine stärker abfallende Kennlinie auf, so dass eine verbesserte Filterwirkung vorliegt. Im Bereich der Grenzfrequenz des Tiefpasses kommt es aber zu unerwünschten Überhöhungen der Ausgangsspannung des Schwingungsfilters 8. Dieses Problem wird durch ein in Figur 3 dargestelltes drittes Schwingungsfilter 14 gemäß dem Stand der Technik beseitigt. Dieses weist im Unterschied zum Schwingungsfilter 8 einen Dämpfungswiderstand R15 im Querzweig auf, welcher die Überhöhung der Ausgangsspannung verringert. Nachteilig an diesem Stand der Technik ist, dass bei hohen Schwingungen große Verlustleistungen in dem Dämpfungswiderstand R15 entstehen.

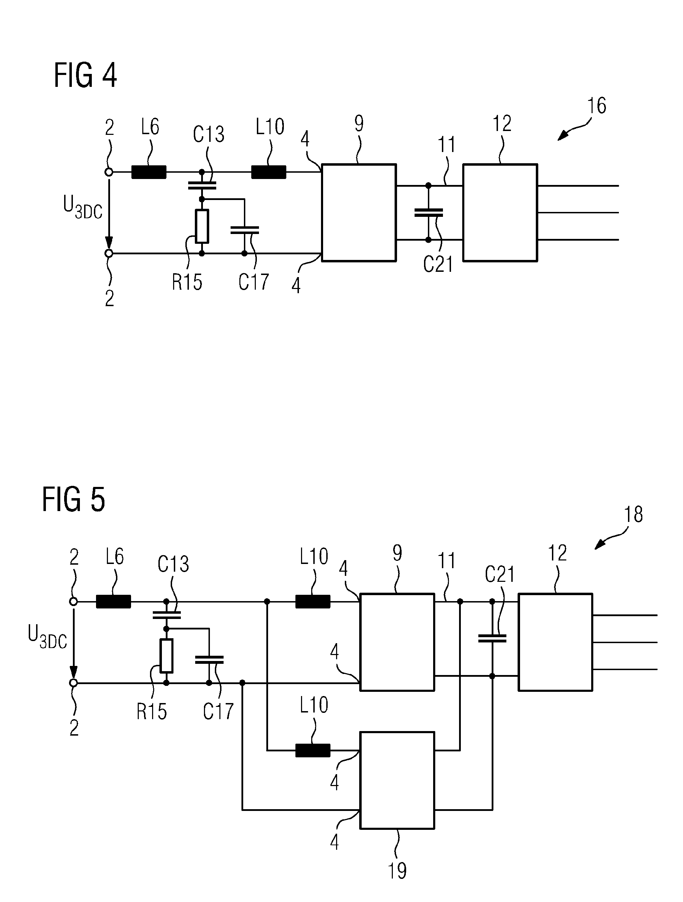

Die Figur 4 zeigt das Schaltbild eines ersten Ausführungsbeispiels des erfindungsgemäßen Schwingungsfilters 16. Das Schwingungsfilter 16 ist zwischen einem Gleichspannungsnetz der Gleichspannung U_{3DC} und einem aus einem Hochsetzsteller 9, einem Gleichspannungszwischenkreis 11 und einem Pulswechselrichter 12 gebildeten Stromrichter angeordnet. Das Schwingungsfilter 16 könnte aber auch an ein beliebiges Versorgungsnetz und an eine andere, störende Oberschwingungsströme produzierende Geräte-Einheit angeschlossen sein. Das Schwingungsfilter 16 umfasst eine Hochsetzstellerdrossel L10 und eine Netzdrossel L6, wobei der Querzweig des Schwingungsfilters 16 zwischen den beiden Induktivitäten abzweigt. Die beiden Induktivitäten könnten aber auch durch eine einzige Induktivität - beispielsweise mit einem Anzapfpunkt für den Querzweig - gebildet sein. Der Querzweig mit einem Kondensator C13 und einem in einem Querzweigabschnitt angeordneten Dämpfungswiderstand R15 ist von einem Überbrückungszweig mit einem Kondensator C17 überbrückt. Der Querzweig wirkt mit der Hochsetzstellerdrossel L10 zusammen als Tiefpass, wobei die gute Filterwirkung des Tiefpasses im Bereich der Grenzfrequenz bzw. Filter-Frequenz von dem Kondensator C17 des Überbrückungszweiges nicht wesentlich beeinflusst ist, da dessen Kapazität so gewählt ist, dass die Grenzfrequenz des durch den Kondensator C17 gebildeten Tiefpasses oberhalb der Filter-Frequenz liegt. Das Entstehen von Verlustleistung, welche insbesondere bei hohen Frequenzen im Dämpfungswiderstand R15 entsteht, wird durch den Überbrückungszweig verhindert.

Die Figur 5 zeigt das Schaltbild eines zweiten Ausführungsbeispiels eines erfindungsgemäßen Schwingungsfilters 18, dessen Geräteanschluss 4 im Unterschied zum erfindungsgemäßen Schwingungsfilter 16 der Figur vier mit einer Geräte-Einheit, bestehend aus zwei Hochsetzstellern 9 und 19, verbunden ist. Die beiden Hochsetzsteller können zeitversetzt getaktet sein. Die hierbei entstehenden Oberschwingungsströme werden von dem gemeinsamen Schwingungsfilter 18 gedämpft, wodurch Bauteile eingespart werden. Der Überbrückungszweig weist genauso wie in der Figur vier dargestellt einen Kondensator C17 auf. Der Überbrückungszweig könnte aber auch andere Kombinationen von Bauteilen aufweisen. Beispielsweise könnte der Überbrückungszweig auch einen Saugkreis oder eine Parallelschaltung eines Tiefpasses und eines Saugkreises aufweisen, wobei der Tiefpass für eine Grenzfrequenz oberhalb der Filter-Frequenz niederimpedant ist und die Resonanzfrequenz des Saugkreises im Bereich einer dominanten Oberschwingung gewählt ist.

Bezugszeichenliste
- 1: ein erstes Schwingungsfilter gemäß dem Stand der Technik
- 2: Netzanschluss
- U_{3DC}: Gleichspannung
- 4: Geräteanschluss
- 5: Stromrichter
- L6: Netzdrossel
- C7: Glättungs-Kondensator
- 8: ein zweites Schwingungsfilter gemäß dem Stand der Technik
- 9: Hochsetzsteller
- L₁₀: Hochsetzstellerdrossel
- 11: Gleichspannungskreis
- 12: Pulswechselrichter
- C13: Kondensator
- 14: ein drittes Schwingungsfilter gemäß dem Stand der Technik
- R15: Dämpfungswiderstand
- 16: ein erstes Ausführungsbeispiel des erfindungsgemäßen Schwingungsfilters
- C17: Kondensator im Überbrückungszweig
- 18: ein zweites Ausführungsbeispiel des erfindungsgemäßen Schwingungsfilters
- 19: Hochsetzsteller
- L20: Induktivität
- C21: Kondensator im Gleichspannungskreis

## Patentansprüche

1. Schwingungsfilter (16, 18) mit
- einem Netzanschluss (2) zum Verbinden mit einem elektrischen Versorgungsnetz und
- einem Geräteanschluss (4) zum Verbinden mit einer Oberschwingungsströme erzeugenden Geräte-Einheit (5, 9, 12, 19),
- mindestens einer Induktivität (L6, L₁₀) und
- mindestens einem parallel zu den Anschlüssen (2, 4) verlaufenden Querzweig,
- wobei einer der Querzweige einen Kondensator (C13) und in Reihe hierzu in einem Querzweigabschnitt mindestens ein weiteres elektrisches Bauteil (R15) umfasst, wobei dem Querzweig eine Filter-Frequenz zugeordnet ist,
**gekennzeichnet durch**
- einen Überbrückungszweig, der den Querzweigabschnitt überbrückt, wobei der Überbrückungszweig bei mindestens einer zweiten Frequenz oberhalb der Filter-Frequenz niederimpedanter ist als der Querzweigabschnitt.

2. Schwingungsfilter (16, 18) nach Anspruch 1,
**dadurch gekennzeichnet, dass**
der Querzweig einen Kondensator (C13) und einen Dämpfungswiderstand (R15) umfasst.

3. Schwingungsfilter (16, 18) nach Anspruch 1 oder 2,
**dadurch gekennzeichnet, dass**
mindestens eine Induktivität (L₁₀) in Reihe zum Geräteanschluss (4) und vom Geräteanschluss (4) aus vor dem Querzweig angeordnet ist.

4. Schwingungsfilter (16, 18) nach einem der Ansprüche 1 bis 3,
**dadurch gekennzeichnet, dass**
der Netzanschluss (2) zum Verbinden mit einem Gleichspannungsnetz vorgesehen ist.

5. Schwingungsfilter (16, 18) nach einem der vorstehenden Ansprüche,
**dadurch gekennzeichnet, dass**
der Geräteanschluss (4) zum Verbinden mit einem steuerbare Leistungshalbleiter aufweisenden Bauteil vorgesehen ist.

6. Schwingungsfilter (16, 18) nach Anspruch 5,
**dadurch gekennzeichnet, dass**
das steuerbare Leistungshalbleiter aufweisende Bauteil ein Umrichter (12), Stromrichter (5), Hochsetzsteller (9, 19) und/oder Tiefsetzsteller ist.

7. Schwingungsfilter (16, 18) nach Anspruch 6,
**dadurch gekennzeichnet, dass**
eine Induktivität durch eine Hochsetzstellerdrossel (L₁₀) realisiert ist.

8. Schwingungsfilter (16, 18) nach einem der vorstehenden Ansprüche,
**gekennzeichnet durch**
eine in Reihe zum Netzanschluss (2) angeordnete Netzdrossel (L6).

9. Schwingungsfilter (16, 18) nach Anspruch 8,
**dadurch gekennzeichnet, dass**
der Querzweig an seinem einen Ende mit einem Anzapfpunkt der Netzdrossel (L6) verbunden ist.

10. Schwingungsfilter (16, 18) nach einem der vorstehenden Ansprüche,
**dadurch gekennzeichnet, dass**
der Überbrückungszweig einen Kondensator (C17) aufweist.

11. Schwingungsfilter (16, 18) nach einem der vorstehenden Ansprüche,
**dadurch gekennzeichnet, dass**
der Überbrückungszweig einen Kondensator (C17) und in Reihe hierzu eine Spule aufweist.

12. Schwingungsfilter (16, 18) nach einem der vorstehenden Ansprüche,
**dadurch gekennzeichnet, dass**
der Überbrückungszweig eine Parallelschaltung aus einem Kondensator (C17) und einem Saugkreis aufweist.
